Europäisches Patentamt

European Patent Office

Office européen des brevets

(19)

(11) Numéro de publication: **0 109 886**
**B1**

(12) # FASCICULE DE BREVET EUROPEEN

(45) Date de publication du fascicule du brevet:
**07.01.88**

(51) Int. Cl.⁴: **G 01 R 23/17**

(21) Numéro de dépôt: **83402165.1**

(22) Date de dépôt: **08.11.83**

(54) Dispositif acousto-optique d'analyse de spectre.

(30) Priorité: **16.11.82 FR 8219141**

(43) Date de publication de la demande:
**30.05.84 Bulletin 84/22**

(45) Mention de la délivrance du brevet:
**07.01.88 Bulletin 88/1**

(84) Etats contractants désignés:
**DE GB NL SE**

(73) Titulaire: **THOMSON-CSF, 173, Boulevard Haussmann, F-75379 Paris Cédex 08 (FR)**

(72) Inventeur: **Huignard, Jean-Pierre, THOMSON-CSF SCPI 173, bld Haussmann, F-75379 Paris Cedex 08 (FR)**

(56) Documents cités:
**US - A - 3 633 995**

**SOVIET PHYSICS TECHNICAL PHYSICS, vol. 27, no. 3, mars 1982, pages 348-349, New York, USA; N.A.ESEPKINA et al.: "Wide-band acoustooptical spectral analyzer for radioastronomy"**
**IEE PROCEEDINGS, Section A-K, vol. 129, no. 3, Partie F, juin 1982, pages 187-193, Old Woking, Surrey, GB; T.R.JOSEPH: "Integrated optic sprectrum analyser"**
**OPTICS COMMUNICATIONS, vol. 35, no. 1, octobre 1980, pages 37-41, Amsterdam, NL; A.ALIPPI et al.: "Real time acousto-optical spectrum analyser through unguided light-surface acoustic waves interaction"**

**Description**

L'invention concerne un dispositif acousto-optique d'analyse de spectre.

Dans un analyseur de spectre acousto-optique de l'art connu une onde acoustique se propage dans un milieu d'interaction et crée en volume un réseau d'indice se déplaçant à la vitesse $V_S$ du son dans le matériau. Le réseau ainsi généré diffracte dans les conditions de Bragg une onde optique incidente. On trouvera une description d'un tel analyseur dans le document «Real time acousto-optical spectrum analyzer through unguided light-surface acoustic wave interaction» de A. ALIPPI et al publié dans la revue Optics communications, volume 35, octobre 1980, numéro 1, pages 37 à 41.

Un réseau linéaire de détecteurs placés dans le plan focal d'une lentille située à la sortie du milieu d'interaction permet d'obtenir l'analyse spectrale du signal envoyé sur le transducteur piézoélectrique qui génère l'onde acoustique dans le milieu interactif. Mais les composants optiques utilisés doivent être limités par diffraction pour obtenir une bonne résolution. Cette condition conduit à la réalisation de lentilles sphériques et cylindriques à faible ouverture numérique rendant le dispositif particulièrement encombrant et au réglage délicat. Afin de pallier cet inconvénient des configurations analogues ont été proposées en technologie optique intégrée.

La difficulté dans ce cas réside dans la fabrication de guides d'ondes à faibles pertes et de lentilles géodésiques à hautes performances.

Par ailleurs le couplage laser-guide, et le couplage guide-détecteur restent des opérations délicates qui entraînent des pertes notables.

Le dispositif de l'invention assure une analyse spectrale du signal avec une résolution élevée. Il présente un encombrement réduit et fonctionne avec une structure optique simple aux limites de la diffraction.

De plus ce dispositif d'analyse de spectre est basé lui aussi sur l'interaction acousto-optique. Il se caractérise par la simplicité de la structure optique adoptée et est compatible avec une résolution élevée. Les applications sont relatives par exemple au domaine de l'avionique (reconnaissance de signatures par exemple) et du traitement de signal.

L'invention a pour objet un dispositif d'analyse de spectre comportant une source lumineuse qui délivre un faisceau lumineux, un milieu d'interaction piézoélectrique et élastooptique, un transducteur réalisé sous la forme d'un peigne interdigité, qui génère une onde acousto-optique dans ce milieu, cette onde acousto-optique étant une onde de surface et créant un réseau d'indice possédant un pas spécifique et se propageant à la vitesse du son dans le milieu, ce transducteur étant attaqué par un signal de commande, l'épaisseur du milieu d'interaction étant supérieure à la longueur d'onde de l'onde de surface; et un réseau linéaire de détecteurs destinés à détecter le spectre de ce signal de commande, le faisceau lumineux étant diffracté par le réseau d'indice pour atteindre le réseau linéaire de détecteurs, caractérisé en ce que le milieu d'interaction est réalisé sous forme d'une calotte shérique, que la source est située au voisinage du centre de courbure et délivre un faisceau lumineux qui éclaire la face concave de la calotte shérique, que ledit réseau linéaire de détecteurs est placé à proximité du centre de courbure dans le plan du spectre à analyser, le transducteur étant déposé sur la face opposée de la calotte shérique par rapport à la source, ledit transducteur en forme de peigne interdigité ayant des doigts orthogonaux audit réseau linéaire de détecteurs.

D'autres caractéristiques et avantages de l'invention apparaîtront dans la description ci-après, en référence aux figures annexées où:
- la figure 1 illustre un dispositif de l'art connu.
- la figure 2 illustre le dispositif selon l'invention.
- les figures 3 et 4 illustrent deux aspects particuliers du dispositif de l'invention.
- la figure 5 illustre une configuration particulière du dispositif selon l'invention.

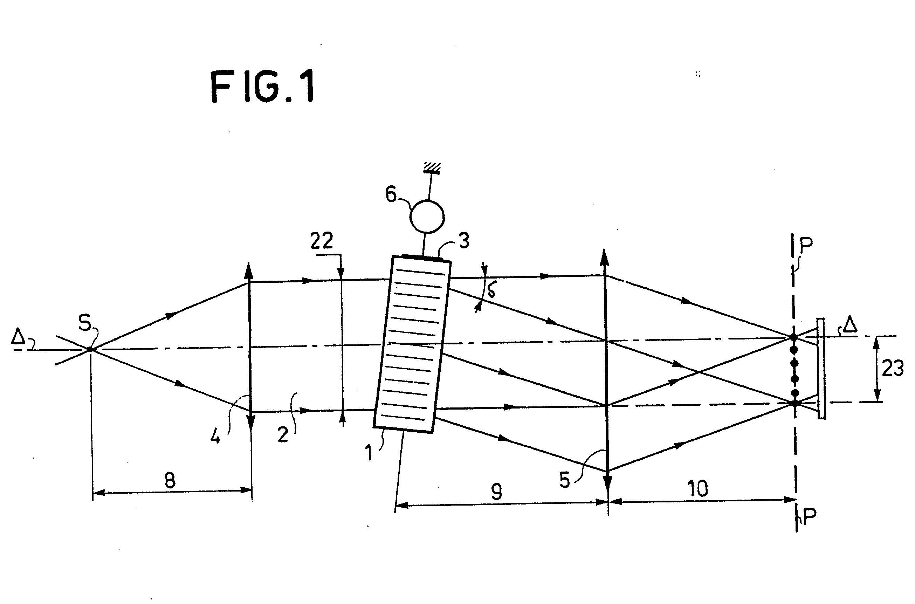

Le schéma d'un analyseur de spectre acousto-optique de l'art connu est donné sur la figure 1. L'onde acoustique se propageant dans le milieu d'interaction 1 crée en volume un réseau d'indice se déplaçant à la vitesse $V_S$ du son dans le matériau.

Le réseau ainsi généré diffracte dans les conditions de Bragg une onde optique plane incidente 2, ce qui explique l'inclinaison du milieu par rapport à l'axe $\Delta$ de direction moyenne de propagation représenté sur la figure 1. Les distances 8, 9 et 10 sont égales aux distances focales respectivement des deux lentilles 4 et 5 ce qui permet d'avoir une onde plane qui atteint le milieu 1, et d'autre part d'avoir un faisceau convergeant dans le plan des détecteurs dont l'axe moyen est toujours parallèle à l'axe $\Delta$.

L'angle $\delta$ entre les deux faisceaux issus du milieu 1 vaut:

$$\delta = \frac{\lambda}{V_s} \times f_l$$

$\lambda$ étant la longueur d'onde de l'onde incidente et $f_1$ étant la fréquence du signal de commande sur le transducteur piézoélectrique 3. Pour chaque fréquence $f_i$ il correspond donc dans le plan focal P de la lentille 5, ou plan Fourier, un point de focalisation dont la position 23 par rapport à l'axe repérée par Xi est donnée par la relation:

$$X_i = \frac{1}{2} \frac{\lambda}{V_s} \times f_i \times F$$

Un réseau linéaire de détecteurs 7 placés dans ce plan P permet d'obtenir l'analyse spectrale du signal 6 envoyé sur le transducteur piézoélectrique 3. Ce signal 6 est un signal haute fréquence situé par exemple entre 100 et 500 MHz. Soit $f_0$ la fréquence centrale du signal de commande et $\Delta F$ la bande de fréquence à analyser, le nombre de points résolus dans le plan de Fourier vaut:

$$N = \Delta F \times \frac{D}{V_s}$$

D étant la hauteur 22 du matériau élasto-optique éclairé par le rayonnement incident, compte tenu des figures de mérite des matériaux habituellement utilisés molybdate de Plomb ($Pb\ Mo\ O_4$); oxyde de télure ($Te\ O_2$), niobate de lithium ($Li\ Nb\ O_3$) . . . des résolutions supérieures à 1000 points sont obtenues.

On doit noter par ailleurs que ces résolutions ne sont effectivement mesurées que si tous les composants optiques utilisés sont limités par diffraction. Cette condition conduit à la réalisation de lentilles sphériques et cylindriques à faible ouverture numérique rendant le dispositif particulièrement encombrant et au réglage délicat. Afin de pallier cet inconvénient des configurations analogues à celle de la figure 1 ont été proposées en technologie optique intégrée sur un substrat de niobate de lithium ($Li\ Nb\ O_3$) par exemple.

La difficulté dans ce cas réside dans la fabrication de guides d'ondes à faibles pertes et de lentilles géodésiques à hautes performances (ouverture numérique; aberrations résiduelles . . .) pour obtenir des fronts d'onde parfaits nécessaires pour entraîner une bonne résolution du dispositif.

Par ailleurs le couplage laser-guide et guide-détecteur restent des opérations délicates qui entraînent des pertes notables au niveau du signal lumineux transmis.

Par contre le dispositif de l'invention assure une analyse spectrale du signal avec une résolution élevée. Il présente un encombrement réduit, et fonctionne avec une structure optique simple aux limites de la diffraction.

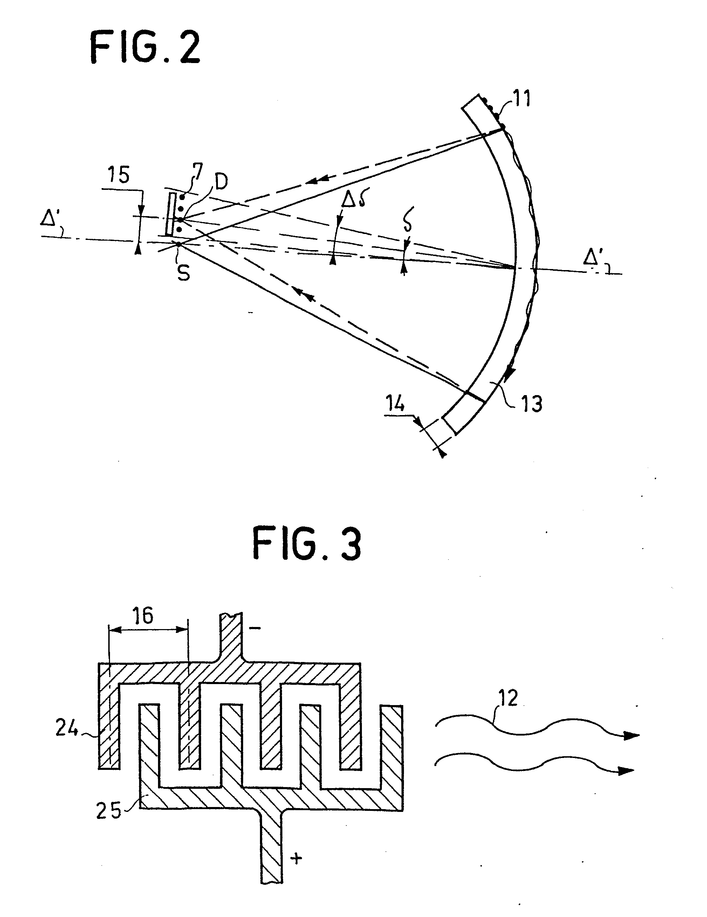

Une représentation schématique de l'invention est réalisée à la figure 2. Elle se compose respectivement:

– d'un point source S issu d'un laser; Laser Hélium-Néon (He Ne), ou à l'Arsenuire de gallium (As Ga) . . ., par exemple, placé au voisinage du centre de courbure d'un «miroir» sphérique 13 réalisé sur un substrat piézoélectrique et élastooptique du type niobate de lithium ($Li\ Nb\ O_3$) par exemple. Le voisinage du centre de courbure concerne la zone de l'espace dans laquelle les propriétés de stigmatisme du faisceau lumineux sont conservées. Cette zone est de l'ordre du degré angulaire par rapport au «miroir» sphérique. La source S peut d'ailleurs, éventuellement être placée en ce centre de courbure. On parle de «miroir», car dans le dispositif de l'invention le milieu considéré est une calotte sphérique qui a les propriétés d'un miroir sphérique. Cette calotte sphérique peut avoir par exemple une hauteur comprise entre 5 et 10 centimètres.

– d'une ligne de détecteurs 7 placée dans le plan du spectre du signal à analyser c'est-à-dire proche du centre de courbure du «miroir». Le nombre de détecteurs utilisés dépend de la résolution désirée dans l'analyse du spectre. Ces détecteurs peuvent être par exemple disposés sur une droite perpendiculaire à l'axe du miroir Δ', et alignés avec la source S. Les ondes acoustiques de surface sont générées à l'aide d'un peigne interdigité, représenté à la figure 3, déposé sur le substrat piézoélectrique par les techniques classiques de photogravure. Si l'on considère une coupe verticale du dispositif comme représentée à la figure 2, le peigne interdigité doit avoir ses doigts disposés perpendiculairement à ce plan de telle sorte que l'onde de surface 12 se déplace dans une direction visible sur cette coupe verticale. La distance 16 entre les lignes médianes de deux doigts de même polarité est égale au pas des strates Λo lié à la fréquence moyenne $f_o$ du signal de commande; on a

$$\Lambda_o = \frac{V_s}{f_o}$$

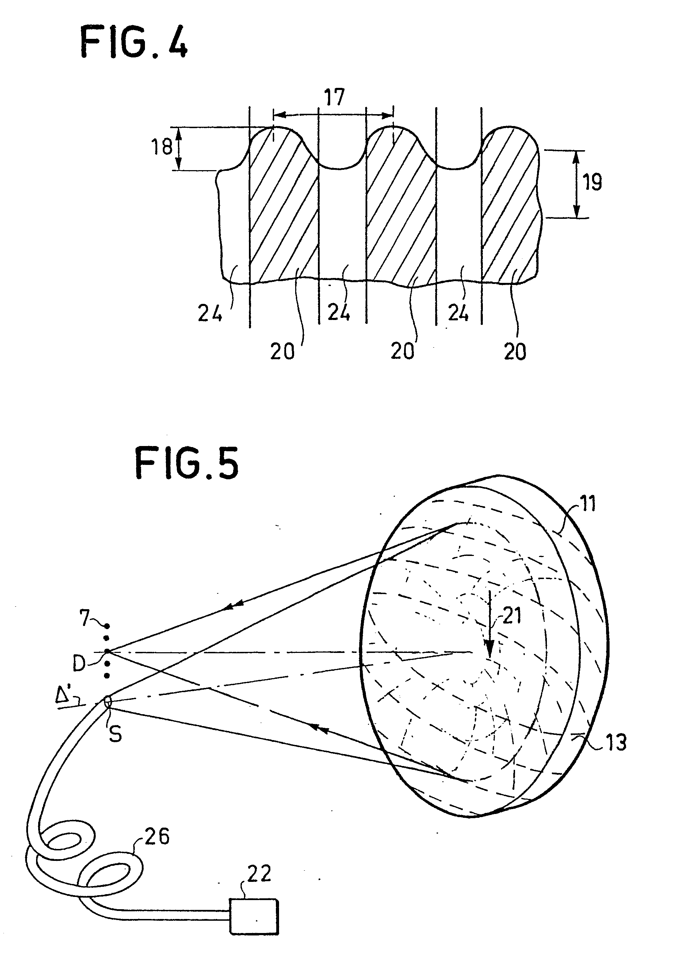

Le passage de l'onde acoustique de surface 12 représentée à la figure 4 s'accompagne de deux effets:

– la surface libre du matériau piézoélectrique, le long de laquelle se propage cette onde de Rayleigh, présente des ondulations périodiques créant un réseau de franges de variation d'indice.

– Il existe un volume limité par la surface libre et dont la profondeur 19 est de l'ordre de grandeur de la longueur d'onde des vibrations de surface. Dans ce volume les déformations induisent des variations de l'indice de réfraction par effet photoélastique créant un réseau de strates d'indices différents 20 et 24. Il y a donc à la fois une modulation spatiale du milieu qui est un milieu élasto-optique par une déformation de la maille cristalline et une variation d'indice dans ce milieu. L'épaisseur du milieu doit donc être supérieure à la longueur d'onde des vibrations de surface c'est-à-dire à des valeurs de quelques micromètres, cette épaisseur peut être, par exemple de l'ordre du millimètre.

En effet les ondes de Rayleigh sont des ondes complexes se progageant à la surface de tout milieu. Elles se composent, dans les cas simples, d'un déplacement longitudinal et d'un déplacement transversal déphasés de $\pi/2$ qui s'annulent définitivement à une profondeur de l'ordre de deux longueurs d'onde. Toutefois cette complexité est compensée par un avantage important: les ondes de Rayleigh peuvent être excitées et détectées sur des substrats piézoélectriques par des transducteurs à doigts de technologie simples et aptes à remplir d'autres fonctions que la conversion électro-mécanique.

Un tel transducteur à électrodes interdigités comprend, comme sur la figure 3, deux électrodes métalliques en forme de peigne déposées sur un substrat piézoélectrique. La tension électrique appliquée entre les deux électrodes crée un champ électrique qui engendre des compressions et des dilatations au voisinage de la surface donnant naissance à différents types d'ondes élastiques. En ce qui concerne les ondes de Rayleigh émises perpendiculairement aux doigts des peignes, le transducteur se comporte comme une suite de sources ultrasonores. Lorsque la tension appliquée est sinusoïdale, les vibrations s'ajoutent de façon constructive seulement si la distance d séparant deux doigts adjacents est égale à une demi-longueur d'onde élastique. En effet toute contrainte produite à l'instant t par une paire de doigts, pour une polarité donnée de la tension appliquée, parcourt à la vitesse $V_R$ des ondes de Rayleigh la distance $\lambda/2$ pendant la demi-période $T/2$. A l'instant $t + T/2$ cette contrainte est arrivée sous la paire de doigts voisine au moment où la tension électrique, qui a changé de signe, produit une contrainte de même phase; l'excitation élastique due à la seconde paire de doigts s'ajoute à celle émise par la première paire. La fréquence $f_o = \dfrac{V_R}{2d}$ qui correspond à cet effet cumulatif est appelée fréquence de synchronisme ou fréquence de résonnance. Si la fréquence s'écarte de cette valeur, l'interférence entre les signaux élastiques émis par les différentes paires de doigts n'est plus totalement constructive et le signal résultant est moindre. Il apparaît ainsi que la bande passante d'un transducteur est d'autant plus faible qu'il comporte plus de doigts.

La fonction de transfert d'un transducteur à N doigts peut se déduire de sa réponse impulsionnelle. Une impulsion brève devant le temps de transit des ondes élastiques entre deux doigts appliquée aux électrodes excite simultanément les N–1 sources ultrasonores. Comme le champ électrique s'inverse à chaque intervalle entre doigts, le signal élastique émis est périodique. La période spatiale est égale au double de la distance d e305ntre les axes de deux doigts adjacentes. La durée $\Theta$ du signal est égale à la longueur active du transducteur $L = (N–1)$ d divisée par la vitesse des ondes de Rayleigh:

$$\theta = \frac{(N-1)d}{V_R} = \frac{(N-1)}{2f_o}.$$

En assimilant intuitivement cette réponse impulsionnelle à un sinusoïde de fréquence $f_O = V_R/2d$ et de durée $\Theta$, la réponse en fréquence égale à la transformée de Fourier de la réponse impulsionnelle apparaît comme une courbe en sin x/x, avec

$$x = \pi\theta(f - f_o) = (N-1)\frac{\pi(f - f_o)}{2f_o}.$$

La bande passante à trois décibels $(x = \pm 0,885\ \pi/2)$ est ainsi inversement proportionnelle au nombre d'intervalles:

$$\frac{\Delta f}{f_o} \simeq \frac{1,77}{N-1}.$$

En pratique, pour relever la réponse impulsionnelle d'un transducteur, il faut transformer le train d'ondes élastiques émis en signal électrique à l'aide d'un transducteur récepteur, à électrodes interdigitées par exemple. Le champ électrique accompagnant l'onde élastique induit, lorsque celle-ci passe sous les électrodes, une différence de potentiel variable au cours du temps. La forme de ce signal dépend du nombre de doigts du récepteur.

La diffraction d'un angle $\Delta$ de l'onde sphérique incidente par le réseau «mince» d'indice et d'épaisseur, dont les profondeurs respectives sont les profondeurs 18 ou d et 19 ou $\Lambda$, est explicitée par la relation:

$$\frac{I_d}{I_o} \simeq R \sin^2 \frac{\Phi}{2}$$

avec:

ø = déphasage apporté après réflexion
R = coefficient de réflexion dû à l'interface du substrat-air.
Id = Intensité lumineuse diffractée et
Io = Intensité lumineuse incidente

La profondeur d(18) correspond donc à la modulation spatiale et la profondeur $\Lambda$(19) à la variation d'indice qui est telle que dans les zones 24 on a un indice égal à n et dans les zones 20 : $n + \Delta n$. On peut considérer les valeurs numériques suivantes, à titre d'exemple:

$$\Phi = 2 \times \frac{2\pi}{\lambda}[\Lambda_o\ \Delta n + (n-1)d]$$

$$\frac{I_d}{I_o} \simeq (\frac{n-1}{n+1})^2 \times \frac{4\pi^2}{\lambda^2}[\Lambda_o\ \Delta n + (n-1)d]^2$$

avec

$\Lambda o$ = pas des strates à la fréquence fo
$\Delta n$ = variation d'indice dans le milieu
n = valeur de l'indice du milieu
$\lambda$ = longueur d'onde de l'onde incidente
On peut considérer par exemple
– Un substrat piézoélectrique en niobate de lithium ($LiNbO_3$)
– Une fréquence centrale $f_o \simeq 150$ MHz.
– Une vitesse de propagation $V_S = 7400$ ms$^{-1}$.
– Un indice n = 2,3
– $\lambda = 0,6$ µm (laser He–Ne).

$$- \Lambda_o = \frac{V_S}{f_o} \simeq 50\ \mu m.$$

Les variations d'indice et d'épaisseur que l'on peut induire sur le substrat sont directement fonction de la puissance électrique du signal de commande. Pour une puissance de l'ordre de quelques 100 mW on obtient pour le niobate de lithium ($LiNbO_3$) les valeurs suivantes:

$$d \simeq 10\ \text{Å (d peut atteindre la valeur 20 Å)}$$

$$\Delta n \simeq 10^{-4}.$$

$$\frac{I_d}{I_o} = 16 \times 10^{-2} \times \frac{40}{0,36}[50\ 10^{-4} + 1,3 \times 10 \times 10^{-4}]^2$$

$$\frac{Id}{Io} \simeq 10^{-3}$$

Résolution de l'analyseur:

$$N = \Delta f \times \frac{D}{V_S}$$

– Bande de fréquence $\Delta F = 150$ MHz
– Dimension du matériau D = 6 cm

$$N = 150 \times 10^{+6} \times \frac{6 \times 10^{-2}}{7400}$$

N = 1200
– Résolution en fréquence
$\delta f = 125$ kHz
temps d'accès
$\tau = 8$ µs
Source laser:
Laser continu Hélium-Néon (HeNe) ou Semiconducteur; Puissance 10 mW.
Puissance disponible par point:

$$\rho = \frac{Pi}{N} = 10 \, nW$$

détection:
barette de $10^3$ détecteurs linéaire.
au pas de 10 µm.
Exemple de réalisation:
diamètre de la calotte sphérique en niobate de lithium ($LiNbO_3$) D = 6 cm.
– Rayon de courbure
R = 15 cm.
– distance moyenne Source-Détecteur SD

$$d = R \times \frac{\lambda}{\Lambda}$$

épaisseur e = 5 mm.
La figure 5 illustre une configuration particulière de l'invention.

La source S est obtenue par l'extrémité d'une fibre optique 26 dont l'autre extrémité est couplée à un laser 22.

Dans le milieu formant «miroir» sphérique 13 les strates 11 se déplacent à la vitesse 21 ou $V_S$ dans une direction perpendiculaire à celle des doigts du peigne interdigité décrit précédemment.

L'onde incidente, après diffraction atteint la ligne de détecteurs 7. Le fait de générer les ondes acoustiques sur la face externe du miroir 13 ou sur la face opposée à la source, présente l'avantage d'entraîner un double passage de l'onde incidente sphérique dans le milieu, et donc un double passage dans le réseau d'indice, tout en tenant compte de la modification du relief sur cette surface externe.

Il y a un effet multiplicatif de l'indice.

Les détecteurs considérés peuvent être, par exemple une ligne de 256 ou de 1024 points. Ce peut être des photodiodes individuelles, ou des «CCD» (ou «Charge Coupled Device») permettant un balayage de tous les détecteurs.

Ainsi le dispositif de l'invention présente l'avantage d'une grande simplicité de la configuration optique qui peut être réalisée avec une très bonne précision (écarts à la surface d'onde inférieurs à $\lambda/4$) et d'une compatibilité avec une résolution élevée de 1000 points par exemple.

**Revendications**

1. Dispositif d'analyse de spectre comportant une source lumineuse (S) qui délivre un faisceau lumineux, un milieu d'interaction piézoélectrique et élastooptique, un transducteur (11), réalisé sous la forme d'un peigne interdigité, qui génère une onde acousto-optique (12) dans ce milieu, cette onde acousto-optique étant une onde de surface et créant un réseau d'indice possédant un pas spécifique et se propageant à la vitesse du son ($V_S$) dans le milieu, ce transducteur étant attaqué par un signal de commande, l'épaisseur du milieu d'interaction étant supérieure à la longueur d'onde de l'onde de surface; et un réseau linéaire de détecteurs (7) destinés à détecter le spectre de ce signal de commande, le faisceau lumineux étant diffracté par le réseau d'indice pour atteindre le réseau linéaire de détecteurs (7), caractérisé en ce que le milieu d'interaction est réalisé sous forme d'une calotte shérique (13), que la source (S) est située au voisinage du centre de courbure et délivre un faisceau lumineux qui éclaire la face concave de la calotte shérique, que ledit réseau linéaire de détecteurs (7) est placé à proximité du centre de courbure dans le plan du spectre à analyser, le transducteur (11) étant déposé sur la face opposée de la calotte shérique (13) par rapport à la source (S), ledit transducteur en forme de peigne interdigité ayant des doigts (24, 25) orthogonaux audit réseau linéaire de détecteurs (7).

2. Dispositif selon la revendication 1, caractérisé en ce que le peigne interdigité comprend deux électrodes (24, 25) dont les doigts de chacune ont leurs lignes médianes séparées d'une longueur (10) égale au pas ($\Lambda o$) des strates à la fréquence moyenne (fo) du signal de commande.

3. Dispositif selon la revendication 1, caractérisé en ce que le milieu interactif est réalisé en niobate de lithium.

4. Dispositif selon la revendication 1, caractérisé en ce que la source est réalisée par l'extrémité d'une fibre optique (26) qui est couplée en son autre extrémité à un laser (22).

**Claims**

1. A spectrum analysis device comprising a light source (S) which supplies a light bundle, a piezoelectric and elasto-optical interaction medium, a transducer (11) having the shape of an interlaced comb and generating an acousto-optical wave (12) in this medium, this acousto-optical wave being a surface wave and creating an index grating of a specific pitch, and being propagated in this medium at sound velocity ($V_S$), this transducer being supplied with a control signal, the thickness of the interaction medium exceeding the wavelength of the surface wave, the device further comprising a linear network of detectors (7) conceived to detect the spectrum of this control signal, the light bundle being refracted by the index grating and being received by the linear network of detectors (7), characterized in that the interaction medium has the shape of a segment of sphere (13), that the source (S) is disposed in the vicinity of the center of curvature and supplies a light bundle illuminating the concave surface of the sphere segment, that the linear network of detectors (7) is situated close to the center of curvature in the plane of the spectrum to be analyzed, the transducer (11) being disposed at the opposite side of the sphere segment (13) with respect to the source (S), said transducer in the form of an interlaced comb having fingers (24, 25) which are perpendicular to said linear network of detectors (7).

2. A device according to claim 1, characterized in that the interlaced comb comprises two electrodes (24, 25), the central lines of the fingers of each electrode being distanced by a length (10) equal to the stratum pitch ($\Lambda$o) at the mean frequency (fo) of the control signal.

3. A device according to claim 1, characterized in that the interactive medium is made of lithium niobate.

4. A device according to claim 1, characterized in that the source is realized by the end of an optical fiber (26), the other end of which is coupled to a laser (22).

**Patentansprüche**

1. Vorrichtung zur Spektralanalyse, mit einer Lichtquelle (S), die ein Lichtbündel liefert, mit einem piezoelektrischen und elasto-optischen Interaktionsmedium, einem Transduktor (11), der in Form eines ineinander verschachtelten Kamms vorliegt und eine akusto-optische Welle (12) in diesem Medium erzeugt, wobei diese akusto-optische Welle eine Oberflächenwelle ist und ein Indexnetz erzeugt, das einen spezifischen Abstand besitzt, wobei diese Welle mit Schallgeschwindigkeit ($V_S$) in diesem Medium fortschreitet und der Transduktor mit einem Steuersignal beaufschlagt wird, wobei die Dicke des Interaktionsmediums grösser als die Wellenlänge der Oberflächenwelle ist, und mit einem linearen Netz von Detektoren (7), die zur Erfassung des Spektrums dieses Steuersignals bestimmt sind, wobei der Lichtstrahl von einem Indexnetz gebrochen wird, um das lineare Netz von Detektoren (7) zu erreichen, dadurch gekennzeichnet, dass das Interaktionsmedium als Kugelkalotte (13) ausgebildet ist, dass die Quelle (S) in der Nähe des Krümmungszentrums liegt und ein Lichtbündel aussendet, das die konkave Seite der Kugelkalotte beleuchtet, dass das lineare Netz von Detektoren (7) in der Nähe des Krümmungszentrums in der Ebene des zu analysierenden Spektrums liegt, wobei der Transduktor (11) auf der der Quelle (S) entgegengesetzten Seite der Kugelkalotte (13) liegt und der Transduktor die Form eines ineinander verschachtelten Kammes besitzt, dessen Zähne (24, 25) senkrecht zu dem linearen Netz von Detektoren (7) verlaufen.

2. Vorrichtung nach Anspruch 1, dadurch gekennzeichnet, dass der ineinander verschachtelte Kamm zwei Elektroden (24, 25) aufweist, deren jeweilige Zähne mit ihren Mittellinien einen Abstand (10) gleich dem Schichtabstand ($\Lambda$o) bei der Mittelfrequenz (fo) des Steuersignals besitzen.

3. Vorrichtung nach Anspruch 1, dadurch gekennzeichnet, dass das interaktive Medium aus Lithiumniobat besteht.

4. Vorrichtung nach Anspruch 1, dadurch gekennzeichnet, dass die Quelle durch das Ende einer optischen Faser (26) gebildet wird, die mit ihrem anderen Ende an einen Laser (22) gekoppelt ist.

# FIG.1

0 109 886

# FIG.2

# FIG.3

# FIG.4

# FIG.5